# EUROPÄISCHE PATENTSCHRIFT

(11) **EP 1 234 866 B1**
(45) Veröffentlichungstag und Bekanntmachung des Hinweises auf die Patenterteilung: **22.08.2007**
(21) Anmeldenummer: 02090077.5
(22) Anmeldetag: 27.02.2002
(51) Int. Cl.: C09K 11/06, H05B 33/14, H01L 51/50

(54) **Organische insbesondere rot elektrolumineszierende Vorrichtung und Dotierstoffe**
Organic, especially red electroluminescent device and doping agents
Dispositif électroluminescent et agents de dopage

(30) Priorität: 27.02.2001 DE 10109464
(43) Veröffentlichungstag der Anmeldung: 28.08.2002
(73) Patentinhaber: Sensient Imaging Technologies GmbH, 06766 Wolfen (DE)
(72) Erfinder: Richter, Andreas, Dr., 06188 Plössnitz (DE); Keil, Dietmar, 06766 Wolfen (DE); Diener, Gerhard, Dr., 06366 Köthen (DE)
(74) Vertreter: Walter, Wolf-Jürgen

(56) Entgegenhaltungen:
- US-A- 2 965 486
- US-A- 5 908 581
- SAWATANI T ET AL: "ENHANCED ELECTROLUMINESCENCE IN ORGANIC LIGHT-EMITTING DIODES UTILIZING CO-DOPEDEMISSIVE LAYER FOR RED LIGHT EMISSION" IEICE TRANSACTIONS ON ELECTRONICS, INSTITUTE OF ELECTRONICS INFORMATION AND COMM. ENG. TOKYO, JP, Bd. E83-C, Nr. 7, Juli 2000 (2000-07), Seiten 1022-1025, XP001072969 ISSN: 0916-8524
- Y. HAMADA ET.AL.: "Red organic light-emitting diodes using an emitting assist dopant" APPLIED PHYSICS LETTERS, Bd. 75, Nr. 12, 1999, Seiten 1682-1684, XP002339044
- S. ERMER ET.AL.: "DCM-polyimide system for triple-stack poled polmer electro-optic devices" APPLIED PHYSICS LETTERS, Bd. 61, Nr. 19, 1992, Seiten 2272-2274, XP002339045

## Beschreibung

Die Erfindung betrifft eine organische insbesondere rot elektrolumineszierende Vorrichtung, speziell eine Vorrichtung mit einer lumineszierenden Schicht, enthaltend mindestens eine lumineszierende Verbindung, oder zusätzlich einen neuen Dotierstoff dafür; sowie neue Verbindungen.

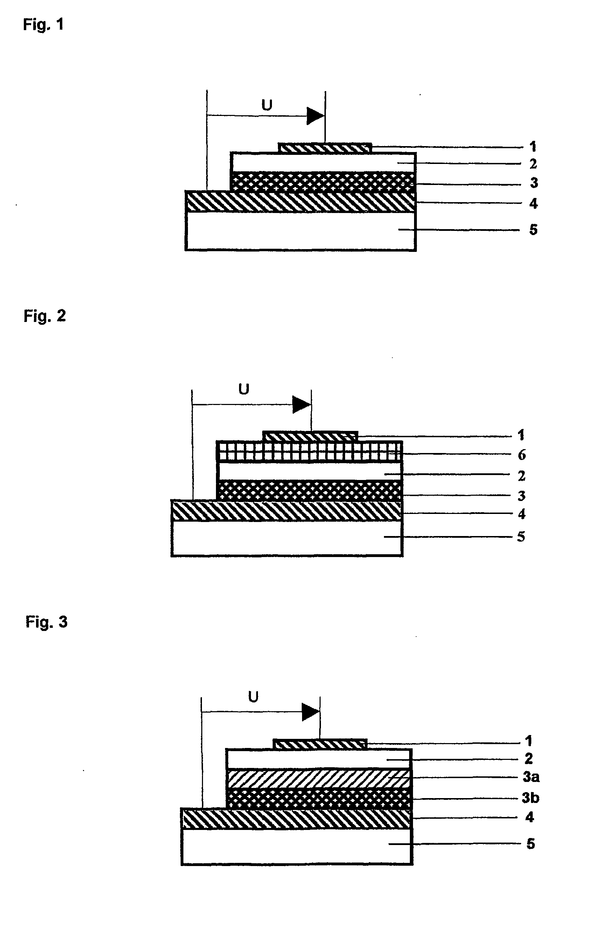

Organische elektrolumineszierende Vorrichtungen sind seit längerer Zeit bekannt und bestehen im einfachsten Falle aus einem Glassubstrat mit einer transparenten Indium-Zinn-Oxid-Beschichtung (ITO), einer Löcher-Transportschicht, gefolgt von einer lumineszierenden Schicht sowie einer Metallelektrode mit niedriger Elektronenaustrittsarbeit (siehe Fig. 1).

Dabei werden in Durchgangsrichtung von der Metallelektrode (Kathode), meist aus Ca oder Mg, durch Co- oder nacheinanderfolgender Verdampfung zum Beispiel mit Al oder Ag hergestellt, Elektronen und vom transparenten ITO-Kontakt (Anode) Löcher (Defektelektronen) in den organischen Schichtverband injiziert. Diese rekombinieren dort und bilden Singulett-Excitonen, die nach kurzer Zeit unter Emission von Licht in den Grundzustand übergehen. Der organische Schichtverband besteht hier aus einer lumineszierenden Schicht (lumineszierende Verbindung ist auch gleichzeitig Elektronenleiter) und einer Löcher-Transportschicht. In der Löcher-Transportschicht werden als Löcher-Transportmaterialien bevorzugt N,N'-Biphenyl-N,N'-bis-(m-tolyl)-benzidin (TPD) und N,N'-Biphenyl-N,N'-bis-(1-naphthyl)-benzidin (1-NPB) eingesetzt. Die zusätzliche Anlagerung einer Elektronen-Transportschicht führt häufig zu einer Erhöhung der Quantenausbeute und oder einer Reduzierung der Einsetzspannung der elektrolumineszierenden Vorrichtung (siehe Fig. 2).

Gleichzeitig kann nun die lumineszierende Schicht sehr dünn ausgeführt werden. Durch die Verwendung von lumineszierenden Material unabhängig von seinen Transporteigenschaften kann die Emissionswellenlänge gezielt im gesamten sichtbaren Spektralbereich eingestellt werden.

Weiterhin erhält man eine Verbesserung der Eigenschaften der elektrolumineszierenden Vorrichtung (Erhöhung der Quantenausbeute und Erniedrigung der Elektrolumineszenz-Einsetzspannung), wenn mindestens zwei aufeinander abgestimmte Löcher-Transportschichten verwendet werden (siehe Fig. 3).

In manchen Fällen kann auch zusätzlich zwischen der lumineszierenden Schicht und der Metallelektrode eine Elektronen-Transportschicht (wie in Fig. 2) aufgebracht werden.

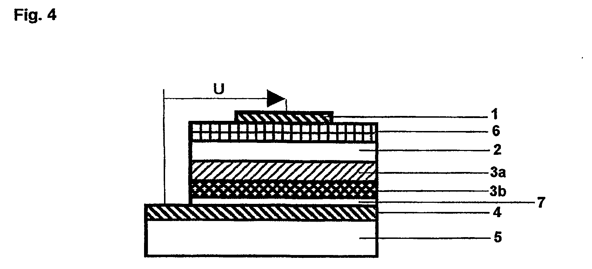

In neuerer Zeit wurde auch zur Verbesserung der Eigenschaften elektrolumineszierender Vorrichtungen eine zusätzliche dünne Löcher-Injektionsschicht aus beispielsweise CuPC (Kupferphthalocyanin) zwischen dem transparenten ITO und der Löcher-transportschicht aufgedampft (siehe Fig. 4).

Insbesondere verwendet man wegen ihres geringen lonisationspotentials in der zweiten Löcher-Transportschicht sog. "Starburst-Moleküle". Das sind hochmolekulare organische Verbindungen auf Basis von Triphenylamin-Einheiten.

Kürzlich wurde in der DE-A-19,541,113 ein neues Löcher-Transportmaterial offengelegt, das neben guten Löcher-Transporteigenschaften auch exzellente schichtbildende Eigenschaften, eine hohe thermische Stabilität und dadurch eine geringe Neigung zur Rekristallisation besitzt.

Für die Herstellung von full-color-tüchtigen elektrolumineszierenden Vorrichtungen ist es notwendig rot, grün und blau elektrolumineszierende Materialien mit hoher Elektrolumineszenz-Quantenausbeute und Farbreinheit zu verwenden.

Seit langer Zeit wird in der lumineszierenden Schicht als bevorzugtes Leuchtmaterial Tris-(8-hydroxychinolino)-aluminium (AlQ)₃ eingesetzt (C.W. Tang, S.A. van Slyke: Appl. Phys. Lett. 51, 1987, 913). Dieser Metallchelatkomplex luminesziert im Schichtverband selbst grün, wobei als Metalle im Komplex auch Beryllium oder Gallium eingesetzt werden können.

Blau elektrolumineszierende Vorrichtungen erhält man durch Verwendung von Derivaten des 1,3,4-Oxadiazols oder durch Verwendung von Distyryl-arylenen. Rote Lumineszenzstrahlung wird insbesondere durch die Dotierung von AlQ₃ mit 2-alkyl-6-N,N-dialkylaminstyryl-substituierten 4-Dicyanomethylen-4H-pyranen, insbesondere aber mit dem 2-Methyl-6-(4-N,N-dimethylaminostyryl)-4-dicyanomethylen-4H-pyran (DCM) (US-A- 4,769,292), aber auch mit Quadratsäurefarbstoffen, erzielt.

Als nachteilig bei der Verwendung von DCM als Dotierstoff von AlQ₃ gilt es zu nennen, daß das emittierte Licht für das menschliche Auge zu orange erscheint, die Effizienz des emittierten Lichts für viele Anwendungen aufgrund von Aggregationseffekten des DCM-Farbstoffs im AlQ₃ nicht ausreichend hoch ist, und die damit gefertigten Leuchtdioden außerdem nicht langzeitstabil genug arbeiten.

Das bereits als Laserfarbstoff bekannt gewordene DCM (US-A-3,852,683) und weitere entsprechend daraus abgeleitete Farbstoffe stellen formal konjugiert polyenische Verbindungen mit einem Donator/Akzeptor-Substituentenmuster dar. Durch Variation der Donatortsubstituenten im Farbstoffmolekül, wie zum Beispiel durch den Austausch des 4-N,N-Dimethylaminophenyl-Rests im DCM durch den wesentlich donatorstärkeren Julolidin-Rest (Farbstoff DCJ), verschieben sich die langwellige Absorptionsbande und parallel dazu auch die Emissionsbande bathochrom gegenüber dem DCM. Bei Verwendung von DCJ in elektrolumineszierenden Vorrichtungen entspricht der visuelle Farbeindruck dann auch einem intensiveren Rot.

Die nachteilige Aggregationstendenz im Anwendungsbereich des Dotierstoffs >1 Gew.% bezogen auf AlQ₃ bleibt aber auch hier bestehen, so daß diese Materialien in elektrolumineszierenden Vorrichtungen zu wenig Effizienz erzeugen. Außerdem sei bei der Verwendung von DCJ auf die schlechte Verdampfbarkeit der Verbindung hingewiesen. Die hohe Zersetzungsrate während des Verdampfungsprozesses führt vor allem zu Problemen bei der Herstellung der lumineszierenden Schicht an sich.

Das Einbringen von sperrigen tert.-butyl-Substituenten in die 2-Position des Pyranrings entsprechender DCM-analoger Farbstoffe, wie in der US-A-5,935,720 genannt, verringert zwar die Aggregationtendenz zum Beispiel der Farbstoffe DCJT und DCJTB gegenüber dem DCJ oder DCM, wobei aber auch diese nicht ausreichend genug unterdrückt werden kann, um Materialien für full-color-taugliche Anwendungen zu Verfügung zu stellen.

Aufgabe der Erfindung war es, eine organische rot elektrolumineszierende Vorrichtung mit verbesserter Quanteneffizienz und verbesserter Langzeitstabilität bereitzustellen und dabei für die lumineszierende Schicht neue lumineszierende Verbindungen und neue Dotierstoffe für bekannte lumineszierende Verbindungen, insbesondere für AlQ₃, zu entwickeln. Eine weitere Aufgabe war die Bereitstellung neuer Verbindungen.

Die organische elektrolumineszierende Vorrichtung besteht im einfachsten Fall aus einem Schichtverband entsprechend der **Fig 1**, aufgebaut aus einer Metallelektrode **1** (Kathode), einer lumineszierenden Schicht **2,** welche neben einer organischen lumineszierenden Verbindung, die insbesondere AlQ₃ ist, mindestens einen organischen Dotierstoff enthält, aus einer Löcher-Transportschicht **3,** welche eine organische Löcher-Transportverbindung enthält, einer transparenten leitfähigen Anode **4,** sowie einem Träger **5** aus Glas oder einem ähnlichen transparenten Material.

Durch einen andersartigen Aufbau der elektrolumineszierenden Vorrichtung, wie zum Beispiel nach den **Fig. 2 und Fig. 3** können die Eigenschaften dieser Vorrichtung optimiert werden.

Erfindungsgemäß besteht die elektrolumineszierende Vorrichtung aus einer Löcher-Transportschicht und einer lumineszierenden Schicht zwischen zwei leitfähigen Elektroden, wobei wenigstens eine Elektrode transparent ist, dadurch gekennzeichnet, daß die lumineszierende Schicht als lumineszierende Verbindung oder als Dotierstoff für eine lumineszierende Verbindung wenigstens eine Verbindung der allgemeinen Formel I enthält 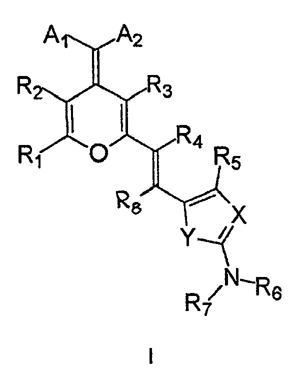 worin
R₁ bis R₁₂ gleich oder verschieden sind und Wasserstoff, geradkettiges oder verzweigtes C₁-C₆-Alkyl, Aralkyl, Aryl oder substituiertes Aryl bedeuten;
R₁ und R₂ und/oder R₃ und R₄ und/oder R₄ und R₅ und/oder R₅ und R₁₁ und/oder R₈ und R₅ und/oder R₄ und R₁₂ können einen bevorzugt 5- oder 6-gliedrigen alicyclischen, heterocyclischen oder aromatischen Ring bilden ;
R₅ kann weiterhin Wasserstoff, OH, OR₉, N,N-Di-(C₁-C₆-)alkylamino, Acetylamino oder Halogen sein;
R₆ und R₇ können zusammen einen alicyclischen oder heterocyclischen Ring bilden;
A₁ und A₂ sind gleich oder verschieden und sind -CN, -NO₂ oder -COOR₈;
X ist -CH, -CR₁₁ oder N; und
Y ist O, -NH, -NR₁₂, S oder Se.

Eine Ausführungsform der Erfindung besteht darin, daß die lumineszierende Schicht als Dotierstoff oder im Gemisch mit weiteren anderen Dotierstoffen für lumineszierende Verbindungen mindestens eine Verbindung enthält, in der die Substituenten R₁ und R₂ oder R₃ und R₄ oder R₁ und R₂ und R₃ und R₄ einen carbocyclischen 5- oder 6-gliedrigen Ring bilden .

Eine weitere Ausführungform der Erfindung besteht darin, daß die lumineszierende Schicht als Dotierstoff für eine lumineszierende Verbindung oder im Gemisch mit weiteren andersartigen Dotierstoffen für lumineszierende Verbindungen mindestens eine Verbindung der allgemeinen Formel II enthält: 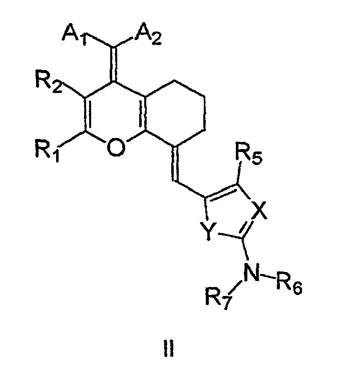 worin
R₁, R₂, R₅ bis R₇ gleich oder verschieden H, geradkettiges oder verzweigtes C₁-C₆-Alkyl, insbesondere iso-Propyl oder tert.-Butyl sein können;
R₁, R₂ einen alicyclischen, heterocyclischen, oder aromatischen, vorzugsweise 5- oder 6-gliedrigen Ring bilden können;
R₁, R₂, R₅, R₆, R₇ gleich oder verschieden Aryl oder substituiertes Aryl sein können;
R₅ gleich OH, OR₈, N,N-dialkylamino (C1-C6), Acetylamino, Halogen sein kann;
R₆ und R₇ gemeinsam einen alicyclischen oder heterocyclischen Ring bilden können;
A₁, A₂ gleich oder verschieden CN, NO₂ oder COOR₈ sein können;
R₈ ist H, geradkettiges oder verzweigtes C₁-C₆-Alkyl oder Aryl;
X ist gleich CH, CR₅ oder N;
Y ist gleich O, NH, NR₈, S oder Se.

Eine weitere Ausführungform der Erfindung besteht darin, daß die lumineszierende Schicht als Dotierstoff für lumineszierende Verbindungen oder im Gemisch mit weiteren andersartigen Dotierstoffen für lumineszierende Verbindungen mindestens eine Verbindung der allgemeinen Formel III enthält: 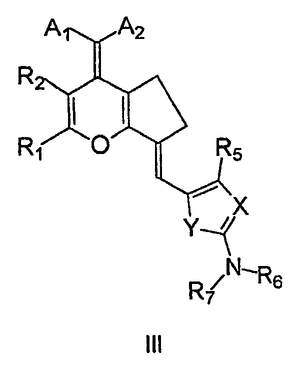 worin
R₁, R₂, R₅ bis R₇ gleich oder verschieden H, geradkettiges oder verzweigtes C₁-C₆-Alkyl, insbesondere iso-Propyl oder tert.-Butyl sein können;
R₁ und R₂ einen alicyclischen, heterocyclischen, oder aromatischen, vorzugsweise 5-oder 6-gliedrigen Ring bilden können;
R₁, R₂, R₅, R₆, R₇ gleich oder verschieden Aryl oder substituiertes Aryl sind;
R₅ ist gleich OH, OR₈, N,N-dialkylamino (C1-C6), Acetylamino, Halogen ;
R₆ und R₇ können zusammen einen alicyclischen oder heterocyclischen Ring bilden;
A₁ und A₂ sind gleich oder verschieden und sind CN, NO₂, COOR₈;
R₈ ist H, geradkettiges oder verzweigtes C₁-C₆-Alkyl oder Aryl;
X ist gleich CH, CR₅ oder N; und
Y ist gleich O, NH, NR₈, S oder Se.

Eine weitere Ausführungform der Erfindung besteht darin, daß die lumineszierende Schicht als Dotierstoff für eine lumineszierende Verbindung oder im Gemisch mit weiteren andersartigen Dotierstoffen für lumineszierende Verbindungen mindestens eine Verbindung der allgemeinen Formel IV enthält: 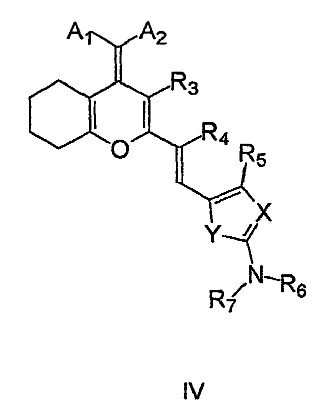 worin
R₃ bis R₇ gleich oder verschieden H, geradkettiges oder verzweigtes C₁-C₆-Alkyl, insbesondere iso-Propyl oder tert.-Butyl sein können;
R₃ und R₄ einen alicyclischen, heterocyclischen oder aromatischen, vorzugsweise 5-oder 6-gliedrigen Ring bilden können;
R₅, R₆ und R₇ können gleich oder verschieden sein und Aryl oder substituiertes Aryl bedeuten;
R₅ kann OH, OR₈, N,N-dialkylamino (C1-C6), Acetylamino oder Halogen sein;
R₆ und R₇ können gemeinsam einen alicyclischen oder heterocyclischen Ring bilden;
A₁, A₂ sind gleich oder verschieden CN, NO₂ oder COOR₈ ;
R₈ ist H, geradkettiges oder verzweigtes C₁-C₆-Alkyl oder Aryl ;
X ist gleich CH, CR₅ oder N;
Y ist gleich O, NH, NR₈, S oder Se.

Eine weitere Ausführungform der Erfindung besteht darin, daß die lumineszierende Schicht als Dotierstoff oder im Gemisch mit weiteren andersartigen Dotierstoffen für lumineszierende Verbindungen mindestens eine Verbindung der allgemeinen Formel V enthält: 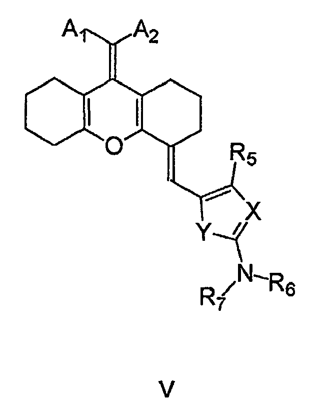 worin
R₅ bis R₇ gleich oder verschieden Aryl, substituiertes Aryl, Wasserstoff, geradkettiges oder verzweigtes C₁-C₆-Alkyl sein können, insbesondere kann R₅ iso-Propyl oder tert.-Butyl sein;
R₅ kann weiterhin OH, OR₈, N,N-dialkylamino (C1-C6), acetylamino oder Halogen sein ;
R₆ und R₇ können gemeinsam einen alicyclischen oder heterocyclischen Ring bilden;
A₁ und A₂ sind gleich oder verschieden CN, NO₂ oder COOR₈,;
R₈ ist H oder geradkettiges oder verzweigtes C₁-C₆-Alkyl;
X ist gleich CH, CR₅ oder N;
Y ist gleich O, NH, NR₈, S oder Se .

Wenn R₁, R₂, R₆ oder R₇ die Bedeutung Aryl haben, ist es vorzugsweise Cycylohexyl oder Phenyl. Vorzugsweise 1 bis 3 Substituenten dafür sind insbesondere C₁-C₆-Alkyl, spezielle Methyl, Isopropyl oder tert-Butyl.

Wenn R₆ und R₇ einen heterocyclischen Ring bilden, ist ein bevorzugtes Heteroatom O. Weitere Heteroatome können N oder S sein.

Eine weitere Ausführungsform der Erfindung besteht darin, daß die lumineszierende Schicht als Dotierstoff oder im Gemisch mit weiteren andersartigen Dotierstoffen für lumineszierende Verbindungen mindestens eine Verbindung enthält, für die A₁ und A₂ jeweils -CN bedeuten.

Vorzugsweise stellen die Reste R₁ bis R₁₂ in der Bedeutung C₁-C₆-Alkyl jeweils Methyl, Isopropyl oder tert-Butyl dar.

Eine weitere Ausführungform der Erfindung besteht darin, daß die Konzentration eines erfindungsgemäßen Dotierstoffs im Gemisch mit einem anderen erfindungsgemäßen Dotierstoff oder mit einem bekannten Dotierstoff lumineszierender Stoffe in der lumineszierenden Schicht im Bereich zwischen 0,1 Gew.% und 50 Gew.%, bezogen auf das Gesamtgewicht aller Dotierstoffe, variiert werden kann. Weiterhin bevorzugt ist, daß die lumineszierende Schicht als lumineszierende Verbindung AlQ₃ enthält.

Es wurde gefunden, daß die neu in elektrolumineszierenden Vorrichtungen eingesetzten neuen und bekannten Verbindungen im Konzentrationsbereich >1 Gew-% bis 8 Gew-%, vorzugsweise >1 bis 5 Gew-%, insbesondere 1,5-3 Gew-%, bezogen auf das Gewicht der organischen lumineszierenden Verbindung AlQ₃, ein sehr effizientes reines rotes Licht allein oder zusammen mit AlQ₃ erzeugen.

Gegenstand der Erfindung sind auch neue Verbindungen der allgemeinen Formel I 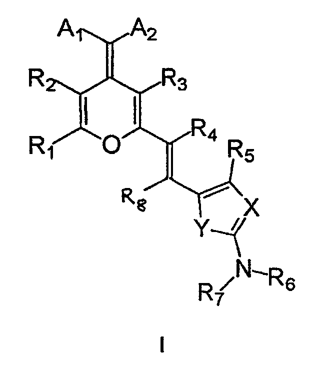 worin
R₁ bis R₁₂ gleich oder verschieden sind und Wasserstoff, geradkettiges oder verzweigtes C₁-C₆-Alkyl, Aralkyl, Aryl oder substituiertes Aryl bedeuten;
R₁ und R₂ und/oder R₃ und R₄ und/oder R₄ und R₅ und/oder R₅ und R₁₁ und/oder R₈ und R₅ und/oder R₄ und R₁₂ können einen bevorzugt 5- oder 6-gliedrigen alicyclischen, heterocyclischen oder aromatischen Ring bilden ;
R₅ kann weiterhin Wasserstoff, OH, OR₉, N,N-Di-(C₁-C₆-)alkylamino, Acetylamino oder Halogen sein;
R₆ und R₇ können zusammen einen alicyclischen oder heterocyclischen Ring bilden;
A₁ und A₂ sind gleich oder verschieden und sind -CN, -NO₂ oder -COOR₈;
X ist -CH, -CR₁₁ oder N; und
Y ist O, -NH, -NR₁₂, S oder Se, mit der Maßgabe, daß Y nicht S ist, wenn X die Bedeutung N und R₅ die Bedeutung Aryl hat.

Man stellt die erfindungsgemäß zu verwendende Vorrichtung nach dem Stand der Technik her, indem man zunächst die Anode als eine transparente leitfähige Schicht von Indium-Zinn-Oxid (ITO) in einer Schichtdicke von 10 nm bis 200 nm auf einen stabilen Glasträger aufbringt. Unmittelbar vor dem Aufbringen der organischen Schichten ist diese ITO-Schicht, insbesondere nach längerer Lagerung, in einem Ultraschallbad nacheinander mit reinem Aceton und Methanol zu behandeln. Nach dem Abblasen von unlöslichen Partikeln mit einem Strahl aus verdampfbaren CO₂-Eiskkristallen wird die Schicht abschließend noch mit einem Sauerstoff-Plasma behandelt, wobei organische Verunreinigungen verbrannt und abgeführt werden.

Ebenfalls nach dem Stand der Technik kann man die Löcher-Transportschicht **3** (HTL) mittels der Spin-Coating-Technik herstellen. Die Löcher-Transportschicht **3** besteht in diesem Fall zum Beispiel aus einer molekularen Dispersion von N,N'-diphenyl-N,N'-bis-(3-methylphenyl)-1,1'-biphenyl-4,4'-diamin (TPD) in Poly-(N-vinylcarbazol) (PVK) oder einem geeigneten Polycarbonat im Gewichts-Verhältnis 1:1, wobei das Verhältnis Löcher-Transportmaterial zu löchertransportierendem Bindemittel oder auch zu einem isolierenden Bindemittel, wie zum Beispiel Polycarbonat, in weiten Grenzen variiert werden kann. Man stellt zunächst eine klare Lösung aus PVK / TPD in einem organischen Lösungsmittel oder Lösungsmittelgemisch, wie zum Beispiel in Methylenchlorid, nach allgemein bekannten Prozeduren in einem Lösegefäß unter Rühren und Inertgas bei Raumtemperatur her und beschichtet anschließend das elektrisch leitfähige transparente Substrat mittels einer Spincoating-Vorrichtung, dahingehend, daß die Löcher-Transportschicht 3 nach dem Trocknen bei 25°C bis 40°C unter Inertgas zum Beispiel in einem Vakuumtrockenschrank eine Trockenschichtdicke von 50 bis 80 nm besitzt. Es sei erwähnt, daß die Löcher-Transportschicht **3** nach dem Stand der Technik, bestehend bevorzugt aus N,N'-diphenyl-N,N'-bis-(3-methylphenyl)-1,1'-biphenyl-4,4'-diamin (TPD) oder N,N'-Biphenyl-N,N'-bis-(1-naphthyl)-benzidin (1-NPB), auch auf den leitfähigen Träger aufgedampft werden kann.

Anschließend bringt man im Hochvakuum auf diese Schicht eine erfindungsgemäß beschriebene Verbindung als Dotierstoff einzeln oder auch als Gemisch mit andersartigen Dotierstoffen mittels Co-Aufdampftechnik gemeinsam mit der lumineszierenden Verbindung, zum Beispiel gemeinsam mit AlQ₃, auf. Dabei kann die Konzentration des Dotierstoffs oder auch eines Dotierstoffgemischs bezogen auf die Gesamtmenge des zu verdampfenden Materials im Konzentrationsbereich zwischen 1 Gew.% und 5 Gew.%, insbesondere bei einer Konzentration zwischen 1,5 Gew.% und 3 Gew.% im Falle der Verwendung von AlQ₃ als lumineszierender Stoff, betragen, um ein rotes Licht zu emittieren.

Die Konzentration des andersartigen Dotierstoffs im Falle der Verwendung eines Gemischs von Dotierstoffen kann dabei, je nach Verwendungszweck der elektrolumineszierenden Vorrichtung, im weiten Bereich, zum Beispiel zwischen 0,1 Gew.% und 50 Gew.%, bezogen auf die Gesamtmenge aller Dotierstoffe variiert werden.

Bei der Lösung der Erfindungsaufgabe wurde als Nebeneffekt überraschend gefunden, daß die organische elektrolumineszierende Vorrichtung im Falle einer "Unterdotierung" der lumineszierenden Verbindung, insbesondere bei einer Unterdotierung von AlQ₃, mit den erfindungsgemäß zu verwendenden Dotierstoffen weißes Licht emittiert.

Eine Unterdotierung liegt dann vor, wenn man den Dotierstoff allein oder im Gemisch mit andersartigen Dotierstoffen in einer Konzentration zwischen 0,1 Gew.% und 1 Gew.%, insbesondere zwischen 0,2 Gew.% und 0,8 Gew.%, bezogen auf die Gesamt menge des zu verdampfenden Materials co-verdampft.

Ohne Zwischenbelüftung trägt man schließlich die Metall-Kathode **1** durch Verdampfung von LiF oder Li-Benzoat und Al, meist im Verhältnis von 10:1 auf (0,7 nm Li-Benzoat + 100 nm Al) auf. Es können aber auch andere Metalle oder Legierungen, oder andere Verhältnisse der Metalle oder Legierungen verwendet werden.

Sehr effiziente rot elektrolumineszierende Vorrichtungen erhält man, wenn in der lumineszierenden Schicht **2** bevorzugt die folgenden Verbindungen **1** bis **18** in der Tabelle als neue, bisher nicht bekannte Dotierstoffe, einzeln oder auch im Gemisch mit anderen geeigneten Dorierstoffen zur Dotierung von AlQ₃ oder anderen lumineszierenden Verbindungen verwendet werden (das Mengenverhältnis gleichartiger Dotierstoffe ist dabei frei wählbar):

**Tabelle**

| | |
|---|---|
| 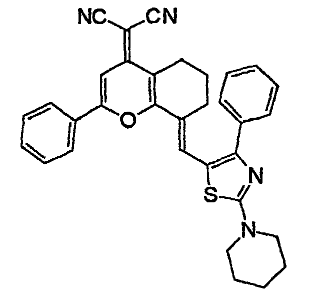 | 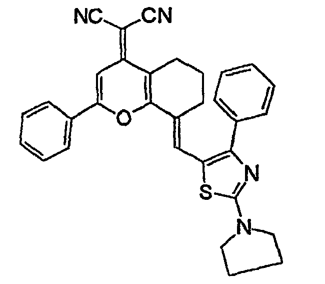 |
| 1 | 2 |
| 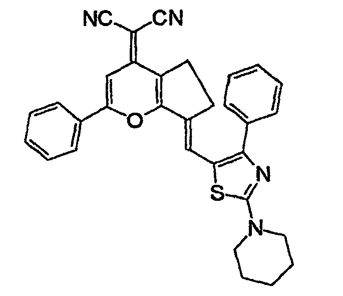 | 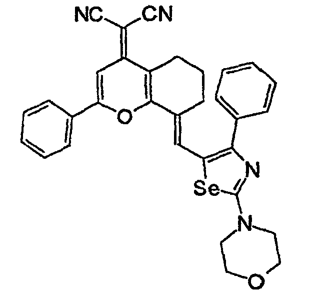 |
| 3 | 4 |
| 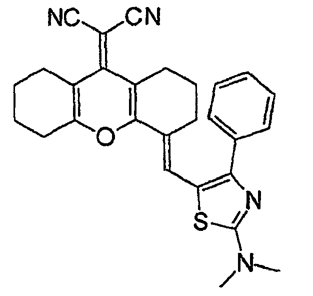 | 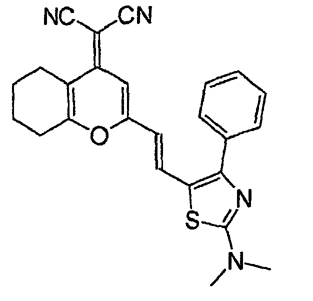 |
| 5 | 6 |
| 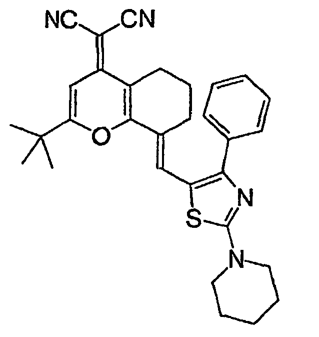 | 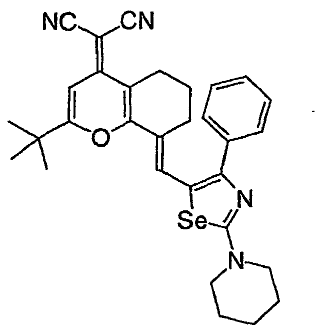 |
| 7 | 8 |
| 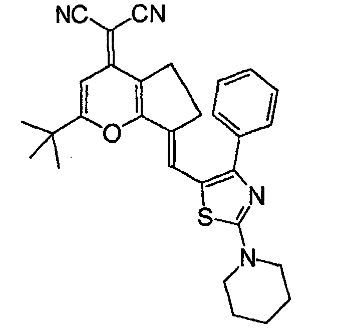 | 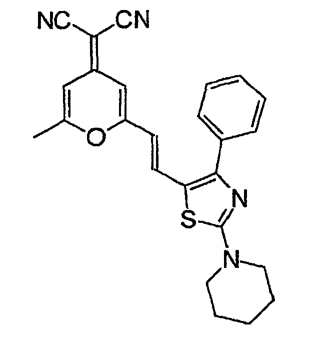 |
| 9 | 10 |
| 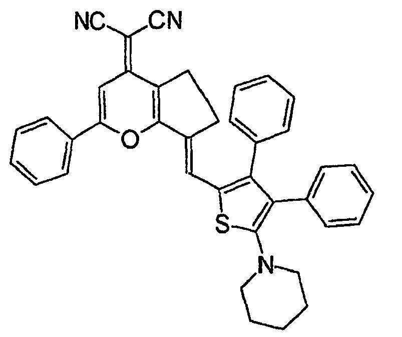 | 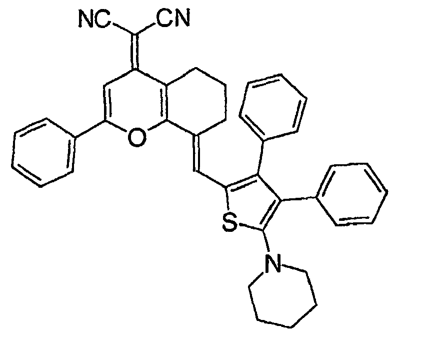 |
| 11 | 12 |
| 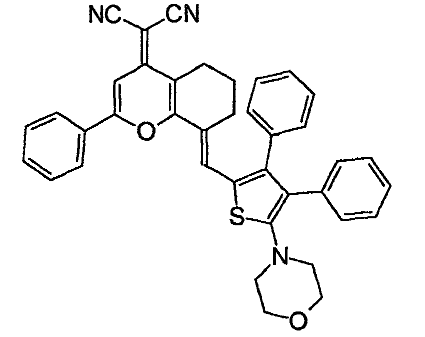 | 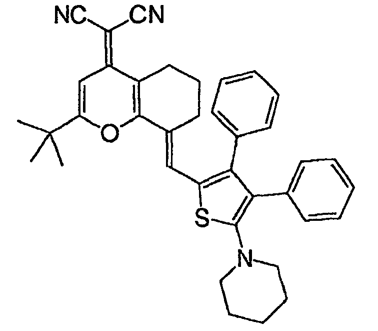 |
| 13 | 14 |
| 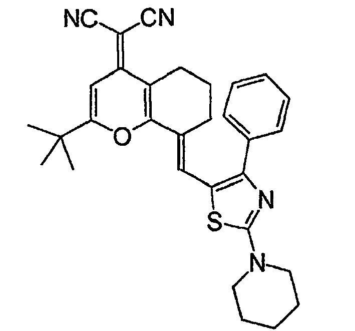 | 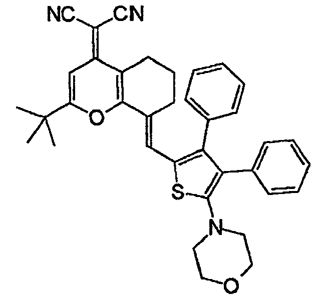 |
| 15 | 16 |
| 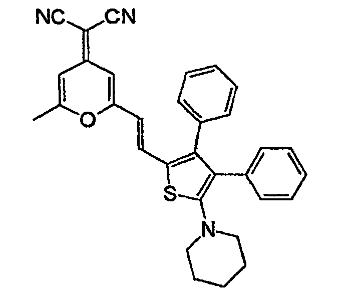 | 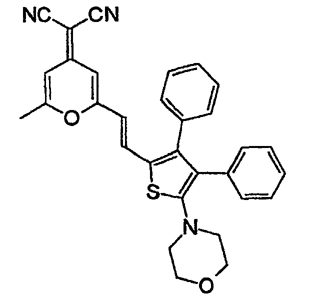 |
| 17 | 18 |

Sehr effiziente rot elektrolumineszierende Vorrichtungen erhält man außerdem, wenn zur Herstellung der lumineszierenden Schicht die neuen Dotierstoffe oder auch Gemische dieser mit einem andersartigen Dotierstoff (zum Beispiel Farbstoffe nach US-A-4,769,292), wie mit einem 1,2- oder 1,3-substituierten Quadratsäurefarbstoff, co-verdampft werden.

Farbstoffe, die erfindungsgemäß als Dotierstoffe für lumineszierende Verbindungen verwendeten werden, sind als solche bekannt und in der DE-A-2,831,054 u.a. zur Herstellung von Bildern nach einem photoelektrophoretischen Verfahren beschrieben.

Bei diesem Verfahren werden durch bildmäßiges Belichten einer Farbstoff enthaltenden elektrisch geladenen Vorrichtung geladene Teilchen in einem elektrischen Feld transportiert, die dann ein positives oder negatives Bild der Vorlage liefern. Diese Verfahrensweise ist völlig andersartig zur Herstellung elektrolumineszierender Vorrichtungen mit den erfindungsgemäß verwendeten Farbstoffen und damit nicht tangierend.

Das allgemeine Herstellungsverfahren der Verbindungen dieses Farbstofftyps ist in der US-A-2,965,486 offenbart.

Die folgenden Beispiele sollen der näheren Erläuterung der Erfindung dienen, wobei die Erfindung nicht nur auf diese beschränkt ist.

In der Zeichnung zeigen
Fig. 1: Einfacher Schichtenaufbau einer elektrolumineszierenden Vorrichtung
Fig. 2: Schichtenaufbau mit zusätzlicher Elektronen-Transportschicht
Fig. 3: Schichtenaufbau mit zusätzlicher Löcher-Transportschicht
Fig. 4: Schichtenaufbau mit zusätzlicher Löcher-Injektionsschicht
In der Zeichnung zeigt U die angelegte Spannung zwischen den entsprechenden Elektroden an.

### Synthesebeispiel

Die Herstellung der erfindungsgemäß einzusetzenden Farbtoffe erfolgt bevorzugt in einer "Eintopfreaktion" nach bekannten Verfahren (siehe US-A-2965486 oder US-A-5908581) aus reaktiven 2-Methyl-4H-pyran-4-onen durch Kondensation zunächst mit Malonitril in Essigsäureanhydrid und anschließender Reaktion mit entsprechenden hetero-aromatischen Aldehyden ohne Isolation der sich zunächst bildenden 4-Dicyanomethylen-2-methyl-4H-pyrane. Die für die Synthese notwendigen heteroaromatischen Aldehyde und ihre Grundkörper erhält man nach bekannten Reaktionsprozeduren gemäß S. Scheithauer et al. in Z.Chem. 8(1968) 182; Hartmann, H. J. Prakt. Chem. 36 (1967) 50; Liebscher, J., Houben-Weyl, Methoden der Organischen Chemie Vol E 8b, Stuttgart 1995, und Organikum, Organisch-chemisches Grundpraktikum, 13. Aufl. VEB Deutscher Verlag der Wissenschaften, Berlin 1974.

### Beispiel 1

Auf einen mit ITO (Indium-Zinn-Oxid) **4** beschichteten Glasträger **5** wird gemäß der **Fig. 1** eine Löcher-Transportschicht (HTL) **3** durch Spin-Coating einer Lösung von N,N'-diphenyl-N,N'-bis-(3-methylphenyl)-benzidin im Gemisch mit Poly-(N-vinylcarbazol) 1:1 (Gewichtsteile) in Dichlormethan aufgetragen. Nach dem Trocknen der Schicht unter Inertgas bei einer Temperatur zwischen 25°C und 40°C beträgt die Schichtdicke 50 nm. Man bringt nun auf die so erhaltene Löcher-Transportschicht **3** im Hochvakuum (10⁻⁵hPa) die lumineszierende Schicht **2** durch Co-Verdampfung von AlQ₃ und dem gereinigten **Farbstoff 1** in einer Konzentration von 1,8 Gew.% bezogen auf AlQ₃ auf. Anschließend wird auf die 60 nm dicke lumineszierende Schicht **2** durch Verdampfung von LiF und Al (0,7 nm LiF + 100 nm AI) die Metall-Kathode **1** aufgebracht.

Zur Messung der Elektrolumineszenz wird zwischen die ITO- und Metallelektrode eine regelbare Spannung zwischen 1 und 20 V angelegt. Die so erhaltene elektrolumineszierende Vorrichtung zeigt eine Leuchtdichte bis zu 400 cd/m² bei 12,5 V. Das emittierte Licht ist frei von Nebenemissionen des AlQ₃ im Bereich um 530 nm und zeigt visuell einen reinen roten Farbton.

### Beispiel 2

Auf einen mit ITO (Indium-Zinn-Oxid) **4** beschichteten Glasträger **5** wird gemäß der **Fig. 1** eine Löcher-Transportschicht (HTL) **3** aus N,N'-diphenyl-N,N'-bis-(3-methylphenyl)-benzidin in einer Schichtdicke von 50 nm im Hochvakuum (10⁻⁵hPa) aufgedampft. Man bringt nun auf die so erhaltene Löcher-Transportschicht **3** die lumineszierende Schicht **2** durch Co-Verdampfung von AlQ₃ und dem gereinigten **Farbstoff 1** in einer Konzentration von 2,2 Gew.% bezogen auf AlQ₃ auf. Die Dicke der aufgedampften lumineszierende Schicht **2** beträgt 60 nm. Anschließend wird durch Verdampfung von Li-Benzoat und Al (0,7 nm Li-Benzoat + 100 nm Al) die Metall-Kathode **1** aufgebracht.

Zur Messung der Elektrolumineszenz wird zwischen die ITO- und Metallelektrode eine regelbare Spannung zwischen 1 und 20 V angelegt. Die so erhaltene Vorrichtung zeigt eine Leuchtdichte bis zu 450 cd/m² bei 13 V. Das emittierte Licht ist frei von Nebenemissionen des AlQ₃ im Bereich um 530 nm und zeigt visuell einen reinen roten Farbton.

### Beispiel 3

Auf einen mit ITO (Indium-Zinn-Oxid) **4** beschichteten Glasträger **5** wird gemäß der **Fig. 2** eine Löcher-Transportschicht (HTL) **3** aus 4,4',4"- Tris-(N-(1-naphthyl)-N-phenyl-amino)-triphenylamin in einer Schichtdicke von 55 nm im Hochvakuum (10⁻⁵hPa) aufgedampft. Man bringt nun auf die so erhaltene Löcher-Transportschicht **3** die lumineszierende Schicht 2 durch Co-Verdampfung von AlQ₃ und dem gereinigten Farbstoff **1** in einer Konzentration von 1,8 Gew.% bezogen auf AlQ₃ auf. Die Dicke der aufgedampften lumineszierende Schicht **2** beträgt 40 nm. Auf diese Schicht dampft man nun 10 nm AlQ₃ als Elektronentransportschicht **6** auf. Anschließend wird durch Verdampfung von Li-Benzoat und Al (0,7 nm Li-Benzoat + 100 nm Al) die Metall-Kathode **1** aufgebracht.

Zur Messung der Elektrolumineszenz wird zwischen die ITO- und Metallelektrode eine regelbare Spannung zwischen 1 und 20 V angelegt. Die so erhaltene elektrolumineszierende Vorrichtung zeigt eine Leuchtdichte bis zu 1000 cd/m² bei 12,5 V. Das emittierte Licht ist frei von Nebenemissionen des AlQ₃ im Bereich um 530 nm und zeigt visuell einen reinen roten Farbton.

### Beispiel 4

Auf einen mit ITO (Indium-Zinn-Oxid) **4** beschichteten gereinigten Glasträger **5** werden gemäß Fig. 4 eine 5 nm dicke Löcher-Injektionsschicht aus CuPC, eine Löcher-Transportschicht (HTL) **3b** aus 4,4',4"- Tris-(N-(1-naphthyl)-N-phenyl-amino)-triphenylamin in einer Schichtdicke von 55 nm und eine weitere Löcher-Transportschicht **3a** aus N,N'-Biphenyl-N,N'-bis-(1-naphthyl)-benzidin (1-NPB) in einer Schichtdicke von 5 nm im Hochvakuum (10⁻⁵hPa) nacheinander aufgedampft. Man bringt nun auf die so erhaltenen Löcher-Transportschichten **3a, 3b** die lumineszierenden Schicht **2** durch Co-Verdampfung von AlQ₃ und dem gereinigten **Farbstoff 1** in einer Konzentration von 2,2 Gew.% bezogen auf AlQ₃ auf. Die Dicke der aufgedampften lumineszierenden Schicht **2** beträgt 40 nm. Auf diese Schicht dampft man nun 5 nm AlQ₃ als Elektronentransportschicht **6** auf. Anschließend wird durch Verdampfung von Li-Benzoat und Al (0,7 nm Li-Benzoat + 100 nm Al) die Metall-Kathode **1** aufgebracht.

Zur Messung der Elektrolumineszenz wird zwischen die ITO- und Metallelektrode eine regelbare Spannung zwischen 1 und 15 V angelegt.

Die so erhaltene Vorrichtung zeigt eine Leuchtdichte bis zu 2050 cd/m² bei 14,0 V. Das emittierte Licht ist frei von Nebenemissionen des AlQ₃ im Bereich um 530 nm und zeigt visuell einen sehr reinen roten Farbton.

### Beispiel 5

Bringt man nun analog dem Schichtaufbau des Beispiels 4 auf die Löchertransportschichten **3a, 3b** die lumineszierende Schicht **2** durch Co-Verdampfung von AlQ₃ und Farbstoff **1** auf, wobei dieser in einer Konzentration von nur 0,7 Gew.% (Unterdotierung) bezogen auf AlQ₃ angewendet wird, so erhält man eine elektrolumineszierende Vorrichtung, die bei einer zwischen ITO- und Metallelektrode angelegten Spannung von 17 V alternativ weißes Licht emittiert.

### Beispiel 6

Auf einen mit ITO (Indium-Zinn-Oxid) **4** beschichteten gereinigten Glasträger **5** gemäß Fig. 4 werden eine 5 nm dicke Löcher-Injektionsschicht aus CuPC, eine Löcher-Transportschicht (HTL) **3b** aus 4,4',4"- Tris-(N-(1-naphthyl)-N-phenyl-amino)-triphenylamin in einer Schichtdicke von 55 nm und eine weitere Löcher-Transportschicht 3a aus 1-NPB in einer Schichtdicke von 5 nm im Hochvakuum (10⁻⁵hPa) nacheinander aufgedampft. Man bringt nun auf die so erhaltenen Löcher-Transportschichten **3a, 3b** die lumineszierenden Schicht **2** durch Co-Verdampfung von AlQ₃ und dem gereinigten **Farbstoff 2** in einer Konzentration von 2,5 Gew.% bezogen auf AlQ₃ auf. Die Dicke der aufgedampften lumineszierenden Schicht **2** beträgt 40 nm. Auf diese Schicht dampft man nun 5 nm AlQ₃ als Elektronentransportschicht **6** auf. Anschließend wird durch Verdampfung von Li-Benzoat und Al (0,7 nm Li-Benzoat + 100 nm Al) die Metall-Kathode 1 aufgebracht.

Zur Messung der Elektrolumineszenz wird zwischen die ITO- und Metallelektrode eine regelbare Spannung zwischen 1 und 15 V angelegt. Die so erhaltene Vorrichtung zeigt eine Leuchtdichte bis zu 2200 cd/m² bei 13,8 V. Das emittierte Licht ist frei von Nebenemissionen des AlQ₃ im Bereich um 530 nm und zeigt visuell einen sehr reinen roten Farbton.

## Patentansprüche

1. Elektrolumineszierende Vorrichtung, bestehend aus einer Löcher-Transportschicht und einer lumineszierenden Schicht zwischen zwei leitfähigen Elektroden, wobei wenigstens eine Elektrode transparent ist,
**dadurch gekennzeichnet, daß** die lumineszierende Schicht als lumineszierende Verbindung oder als Dotierstoff für eine lumineszierende Verbindung wenigstens eine Verbindung der allgemeinen Formel I enthält 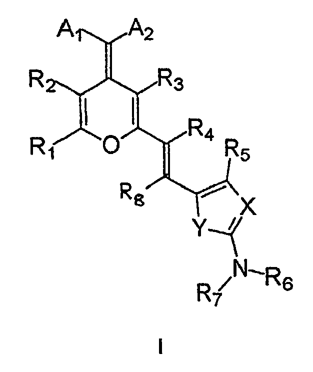 worin
R₁ bis R₁₂ gleich oder verschieden sind und Wasserstoff, geradkettiges oder verzweigtes C₁-C₆-Alkyl, Aralkyl, Aryl oder substituiertes Aryl bedeuten;
R₁ und R₂ und/oder R₃ und R₄ und/oder R₄ und R₅ und/oder R₅ und R₁₁ und/oder R₈ und R₅ und/oder R₄ und R₁₂ können einen bevorzugt 5- oder 6-gliedrigen alicyclischen, heterocyclischen oder aromatischen Ring bilden ;
R₅ kann weiterhin Wasserstoff, OH, OR₉, N,N-Di-(C₁-C₆-)alkylamino, Acetylamino oder Halogen sein;
R₆ und R₇ können zusammen einen alicyclischen oder heterocyclischen Ring bilden;
A₁ und A₂ sind gleich oder verschieden und sind -CN, -NO₂ oder -COOR₈;
X ist -CH, -CR₁₁ oder N; und
Y ist O, -NH, -NR₁₂, S oder Se.

2. Vorrichtung nach Anspruch 1, **dadurch gekennzeichnet, daß** die lumineszierende Schicht als Dotierstoff oder im Gemisch mit weiteren anderen Dotierstoffen für lumineszierende Verbindungen mindestens eine Verbindung enthält, in der die Substituenten R₁ und R₂ oder R₃ und R₄ oder R₁ und R₂ und R₃ und R₄ einen carbocyclischen 5- oder 6-gliedrigen Ring bilden.

3. Vorrichtung nach Anspruch 1, **dadurch gekennzeichnet, daß** die lumineszierende Schicht als Dotierstoff oder im Gemisch mit weiteren andersartigen Dotierstoffen für lumineszierende Verbindungen mindestens eine Verbindung der allgemeinen Formel II enthält: 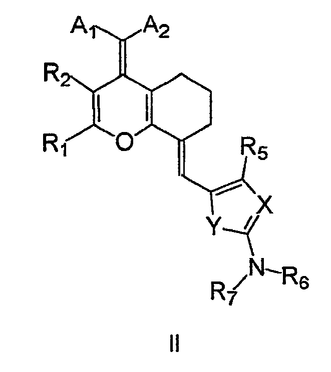 worin
R₁, R₂, R₅ bis R₇ gleich oder verschieden H, geradkettiges oder verzweigtes C₁-C₆-Alkyl, insbesondere Isopropyl oder tert.-Butyl sein können;
R₁, R₂ einen alicyclischen, heterocyclischen, oder aromatischen, vorzugsweise 5- oder 6-gliedrigen Ring bilden können;
R₁, R₂, R₆, R₇ gleich oder verschieden Aryl oder substituiertes Aryl sein können;
R₅ gleich OH, OR₈, N,N-dialkylamino (C1-C6), Acetylamino, Halogen sein kann;
R₆ und R₇ gemeinsam einen alicyclischen oder heterocyclischen Ring bilden können;
A₁, A₂ gleich oder verschieden CN, NO₂ oder COOR₈ sein können;
R₈ ist H, geradkettiges oder verzweigtes C₁-C₆-Alkyl oder Aryl;
X ist gleich CH, CR₅ oder N;
Y ist gleich O, NH, NR₈, S oder Se.

4. Vorrichtung nach Anspruch 1, **dadurch gekennzeichnet, daß** die lumineszierende Schicht als Dotierstoff oder im Gemisch mit weiteren andersartigen Dotierstoffen für lumineszierende Verbindungen mindestens eine Verbindung der allgemeinen Formel III enthält: 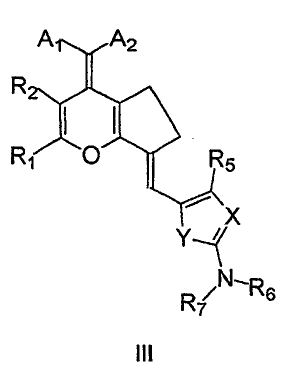 worin
R₁, R₂, R₅ bis R₇ gleich oder verschieden H, geradkettiges oder verzweigtes C₁-C₆-Alkyl, insbesondere Isopropyl oder tert.-Butyl sein können;
R₁ und R₂ einen alicyclischen, heterocyclischen, oder aromatischen, vorzugsweise 5-oder 6-gliedrigen Ring bilden können;
R₁, R₂, R₅, R₆, R₇ gleich oder verschieden Aryl oder substituiertes Aryl sind;
R₅ ist gleich OH, OR₈, N,N-dialkylamino (C1-C6), Acetylamino, Halogen ;
R₆ und R₇ können zusammen einen alicyclischen oder heterocyclischen Ring bilden;
A₁ und A₂ sind gleich oder verschieden und sind CN, NO₂, COOR₈;
R₈ ist H, Alkyl geradkettiges oder verzweigtes C₁-C₆-Alkyl oder Aryl;
X ist gleich CH, CR₅ oder N; und
Y ist gleich O, NH, NR₈, S oder Se.

5. Vorrichtung nach Anspruch 1, **dadurch gekennzeichnet, daß** die lumineszierende Schicht als Dotierstoff oder im Gemisch mit weiteren andersartigen Dotierstoffen für lumineszierende Verbindungen mindestens eine Verbindung der allgemeinen Formel IV enthält: 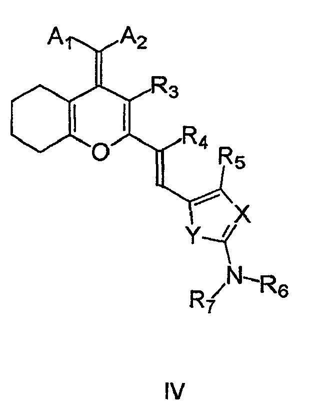 worin
R₃ bis R₇ gleich oder verschieden H, geradkettiges oder verzweigtes C₁-C₆-Alkyl, insbesondere Isopropyl oder tert.-Butyl sein können;
R₃, R₄ einen alicyclischen, heterocyclischen, oder aromatischen, vorzugsweise 5- oder 6-gliedrigen Ring bilden können;
R₅, R₆, R₇ sind gleich oder verschieden Aryl oder substituiertes Aryl;
R₅ Kann OH, OR₈, N,N-dialkylamino (C1-C6), Acetylamino oder Halogen sein;
R₆ und R₇ können gemeinsam einen alicyclischen oder heterocyclischen Ring bilden;
A₁, A₂ sind gleich oder verschieden CN, NO₂ oder COOR₈ ;
R₈ ist H, geradkettiges oder verzweigtes C₁-C₆-Alkyl oder Aryl;
X ist gleich CH, CR₅ oder N;
Y ist gleich O, NH, NR₈, S oder Se.

6. Vorrichtung nach Anspruch 1, **dadurch gekennzeichnet, daß** die lumineszierende Schicht als Dotierstoff oder im Gemisch mit weiteren andersartigen Dotierstoffen für lumineszierende Verbindungen mindestens eine Verbindung der allgemeinen Formel V enthält: 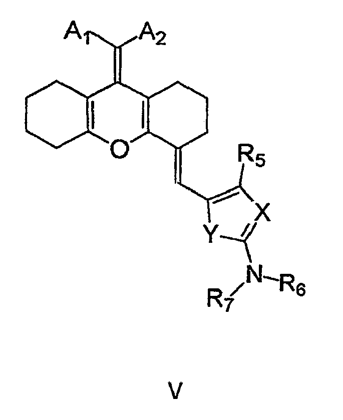 worin
R₅ bis R₇ gleich oder verschieden H, geradkettiges oder verzweigtes C₁-C₆-Alkyl, insbesondere R₅ Isopropyl oder tert.-Butyl sein können;
R₅ bis R₇ gleich oder verschieden Aryl oder substituiertes Aryl sind;
R₅ ist gleich OH, OR₈, N,N-dialkylamino (C1-C6), acetylamino oder Halogen;
R₆ und R₇ können gemeinsam einen alicyclischen oder heterocyclischen Ring bilden;
A₁ und A₂ sind gleich oder verschieden CN, NO₂ oder COOR₈;
R₈ ist Wasserstoff oder geradkettiges oder verzweigtes C₁-C₆-Alkyl;
X ist gleich CH, CR₅ oder N;
Y ist gleich O, NH, NR₈, S oder Se .

7. Vorrichtung nach einem der Ansprüche 1 bis 6, **dadurch gekennzeichnet, daß** die Reste R₁ bis R₁₂ in der Bedeutung C₁-C₆-Alkyl jeweils Methyl, Isopropyl oder tert-Butyl darstellen.

8. Vorrichtung nach einem der Ansprüche 1 bis 7, **dadurch gekennzeichnet, daß** die Konzentration eines Dotierstoffs oder eines Dotierstoffgemischs in der lumineszierenden Schicht zwischen 1 Gew.% und 5 Gew.%, insbesondere zwischen 1,5 Gew.% und 3 Gew.% bezogen auf die Menge des lumineszierenden Stoffs, insbesondere bezogen auf AlQ₃ beträgt.

9. Vorrichtung nach einem der Ansprüche 1 bis 8, **dadurch gekennzeichnet, daß** die lumineszierende Schicht als lumineszierende Verbindung bevorzugt AlQ₃ enthält.

10. Vorrichtung nach Anspruch 8 oder 9, **dadurch gekennzeichnet, daß** sie eine reine rote Lichtemission erzeugt.

11. Vorrichtung nach einem der Ansprüche 1 bis 10, **dadurch gekennzeichnet, daß** die lumineszierende Schicht als Dotierstoff oder im Gemisch mit weiteren andersartigen Dotierstoffen für lumineszierende Verbindungen mindestens eine Verbindung enthält, für die A₁ und A₂ jeweils -CN bedeuten.

12. Vorrichtung nach einem der Ansprüche 1 bis 11, **dadurch gekennzeichnet, daß** die Konzentration eines Dotierstoffs im Gemisch mit einem andersartigen Dotierstoff lumineszierender Stoffe in der lumineszierenden Schicht im Bereich, zwischen 0,1 Gew.% und 50 Gew.% bezogen auf das Gesamtgewicht aller Dotierstoffe variiert wird.

13. Vorrichtung nach einem der Ansprüche 1 bis 7, **dadurch gekennzeichnet, daß** die Konzentration der Dotierstoffe im Bereich von 0,1 bis 1 Gew-% liegt, bezogen auf das Gewicht der lumineszierenden Verbindung AlQ₃, vorzugsweise 0,1 -0,8 Gew-%, und daß sie bei Verwendung von AlQ₃ als lumineszierende Verbindung ein weißes Licht erzeugt.

14. Verbindungen der allgemeinen Formel I 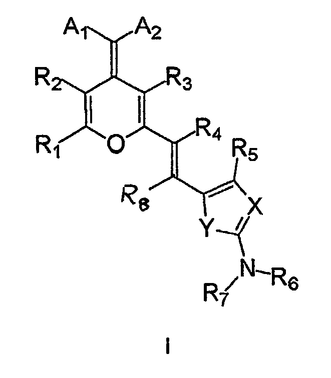 worin
R₁ bis R₁₂ gleich oder verschieden sind und Wasserstoff, geradkettiges oder verzweigtes C₁-C₆-Alkyl, Aralkyl, Aryl oder substituiertes Aryl bedeuten;
R₁ und R₂ und/oder R₃ und R₄ und/oder R₄ und R₅ und/oder R₅ und R₁₁ und/oder R₈ und R₅ und/oder R₄ und R₁₂ können einen bevorzugt 5- oder 6-gliedrigen alicyclischen, heterocyclischen oder aromatischen Ring bilden ;
R₅ kann weiterhin Wasserstoff, OH, OR₉, N,N-Di-(C₁-C₆-)alkylamino, Acetylamino oder Halogen sein;
R₆ und R₇ können zusammen einen alicyclischen oder heterocyclischen Ring bilden;
A₁ und A₂ sind gleich oder verschieden und sind -CN, -NO₂ oder -COOR₈;
X ist -CH, -CR₁₁ oder N; und
Y ist O, -NH, -N R₁₂, S oder Se, mit der Maßgabe, daß Y nicht S ist, wenn X die Bedeutung N und R₅ die Bedeutung Aryl hat.

## Claims

1. An electroluminescent device, said device consisting of a hole transport layer and a luminescent layer between two conductive electrodes, with at least one electrode being transparent,
**characterized in that** the luminescent layer includes as luminescent compound or as dopant for a luminescent compound at least one compound of general formula I 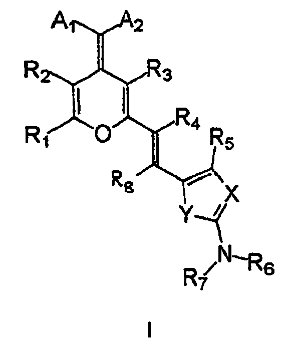 wherein
R₁ to R₁₂ are the same or different and represent hydrogen, straight-chain or branched C₁-C₆ alkyl, aralkyl, aryl or substituted aryl;
R₁ and R₂ and/or R₃ and R₄ and/or R₄ and R₅ and/or R₅ and R₁₁ and/or R₈ and R₅ and/or R₄ and R₁₂ may form a preferably 5- or 6-membered alicyclic, heterocyclic or aromatic ring;
R₅ can also be hydrogen, OH, OR₉, N,N-di(C₁-C₆)alkylamino, acetylamino or halogen;
R₆ and R₇, taken together, may form an alicyclic or heterocyclic ring;
A₁ and A₂ are the same or different and are -CN, -NO₂ or -COOR₈;
X is -CH, -CR₁₁ or N; and
Y is O, -NH, -NR₁₂, S or Se.

2. The device according to claim 1, **characterized in that** the luminescent layer includes as dopant or in mixture with additional other dopants for luminescent compounds at least one compound wherein the substituents R₁ and R₂ or R₃ and R₄ or R₁ and R₂ and R₃ and R₄ form a carbocyclic 5- or 6-membered ring.

3. The device according to claim 1, **characterized in that** the luminescent layer includes as dopant or in mixture with additional different dopants for luminescent compounds at least one compound of general formula II: 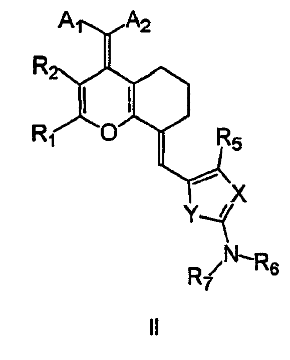 wherein
R₁, R₂, R₅ to R₇, same or different, can be H, straight-chain or branched C₁-C₆ alkyl, particularly isopropyl or t-butyl;
R₁, R₂ may form an alicyclic, heterocyclic or aromatic, preferably 5- or 6-membered ring;
R₁, R₂, R₆, R₇, same or different, can be aryl or substituted aryl;
R₆ can be OH, OR₈, N,N-dialkylamino(C₁-C₆), acetylamino, halogen;
R₆ and R₇, taken together, may form an alicyclic or heterocyclic ring;
A₁, A₂, same or different, can be CN, NO₂ or COOR₈;
R₈ is H, straight-chain or branched C₁-C₆ alkyl or aryl;
X is CH, CR₅ or N;
Y is O, NH, NR₈, S or Se.

4. The device according to claim 1, **characterized in that** the luminescent layer includes as dopant or in mixture with additional different dopants for luminescent compounds at least one compound of general formula III: 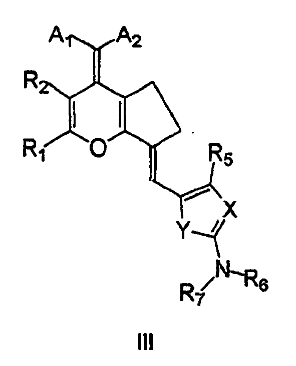 wherein
R₁, R₂, R₅ to R₇, same or different, can be H, straight-chain or branched C₁-C₆ alkyl, particularly isopropyl or t-butyl;
R₁ and R₂ may form an alicyclic, heterocyclic or aromatic, preferably 5- or 6-membered ring;
R₁, R₂, R₅, R₆, R₇, same or different, can be aryl or substituted aryl;
R₅ is OH, OR₈, N,N-dialkylamino(C₁-C₆), acetylamino, halogen;
R₆ and R₇, taken together, may form an alicyclic or heterocyclic ring;
A₁ and A₂ are the same or different and are CN, NO₂, COOR₈;
R₈ is H, straight-chain or branched C₁-C₆ alkyl or aryl;
X is CH, CR₅ or N; and
Y is O, NH, NR₈, S or Se.

5. The device according to claim 1, **characterized in that** the luminescent layer includes as dopant or in mixture with additional different dopants for luminescent compounds at least one compound of general formula IV: 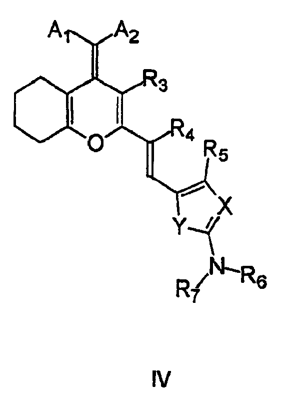 wherein
R₃ to R₇, same or different, can be H, straight-chain or branched C₁-C₆ alkyl, particularly isopropyl or t-butyl;
R₃, R₄ may form an alicyclic, heterocyclic or aromatic, preferably 5- or 6-membered ring;
R₅, R₆, R₇, same or different, are aryl or substituted aryl;
R₅ can be OH, OR₈, N,N-dialkylamino(C₁-C₆), acetylamino, or halogen;
R₆ and R₇, taken together, may form an alicyclic or heterocyclic ring;
A₁, A₂, same or different, are CN, NO₂ or COOR₈;
R₈ is H, straight-chain or branched C₁-C₆ alkyl or aryl;
X is CH, CR₅ or N;
Y is O, NH, NR₈, S or Se.

6. The device according to claim 1, **characterized in that** the luminescent layer includes as dopant or in mixture with additional different dopants for luminescent compounds at least one compound of general formula V: 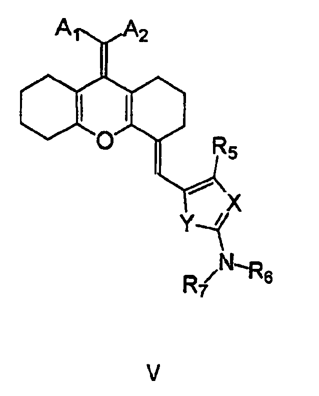 wherein
R. to R₇, same or different, can be H, straight-chain or branched C₁-C₆ alkyl, and particularly R₅ can be isopropyl or t-butyl;
R₅ to R₇, same or different, are aryl or substituted aryl;
R₅ is OH, OR₈, N,N-dialkylamino(C₁-C₆), acetylamino, halogen;
R₆ and R₇, taken together, may form an alicyclic or heterocyclic ring;
A₁ and A₂, same or different, are CN, NO₂ or COOR₈;
R₈ is hydrogen or straight-chain or branched C₁-C₆ alkyl;
X is CH, CR₅ or N;
Y is O, NH, NR₈, S or Se.

7. The device according to any of claims 1 to 6, **characterized in that** each residue R₁ to R₁₂, when representing C₁-C₆ alkyl, represents methyl, iso-propyl or t-butyl.

8. The device according to any of claims 1 to 7, **characterized in that** the concentration of a dopant or of a dopant mixture in the luminescent layer is between 1 wt.-% and 5 wt.-%, particularly between 1.5 wt.-% and 3 wt.-%, relative to the amount of luminescent material, particularly relative to AlQ₃.

9. The device according to any of claims 1 to 8, **characterized in that** the luminescent layer preferably includes AlQ₃ as luminescent compound.

10. The device according to claim 8 or 9, **characterized in that** the device produces a pure red light emission.

11. The device according to any of claims 1 to 10, **characterized in that** the luminescent layer includes as dopant or in mixture with additional different dopants for luminescent compounds at least one compound wherein each A₁ and A₂ represents -CN.

12. The device according to any of claims 1 to 11, **characterized in that** the concentration of a dopant in mixture with a different dopant of luminescent materials in the luminescent layer is varied in a range between 0.1 wt.-% and 50 wt.-%, relative to the total weight of all dopants.

13. The device according to any of claims 1 to 7, **characterized in that** the concentration of the dopants ranges from 0.1 to 1 wt.-%, relative to the weight of the luminescent compound AlQ₃, preferably from 0.1 to 0.8 wt.-%, and that the device produces white light when AlQ₃ is used as luminescent compound.

14. Compounds of general formula I 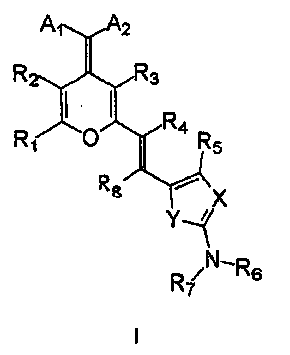 wherein
R₁ to R₁₂ are the same or different and represent hydrogen, straight-chain or branched C₁-C₆ alkyl, aralkyl, aryl or substituted aryl;
R₁ and R₂ and/or R₃ and R₄ and/or R₄ and R₅ and/or R₅ and R₁₁ and/or R₈ and R₅ and/or R₄ and R₁₂ may form a preferably 5- or 6-membered alicyclic, heterocyclic or aromatic ring;
R₅ can also be hydrogen, OH, OR₉, N,N-di(C₁-C₆)alkylamino, acetylamino or halogen;
R₆ and R₇, taken together, may form an alicyclic or heterocyclic ring;
A₁ and A₂ are the same or different and are -CN, -NO₂ or -COOR₈;
X is -CH, -CR₁₁ or N; and
Y is O, -NH, -NR₁₂, S or Se, with the proviso that Y is not S if X represents N and R₅ represents aryl.

## Revendications

1. Dispositif électroluminescent, consistant en une couche de transport de trou et en une couche luminescente entre deux électrodes conductrices, où au moins une électrode est transparente,
**caractérisé en ce que** la couche luminescente contient comme composé luminescent ou comme substance de dopage pour un composé luminescent, au moins un composé de la formule générale 1 : 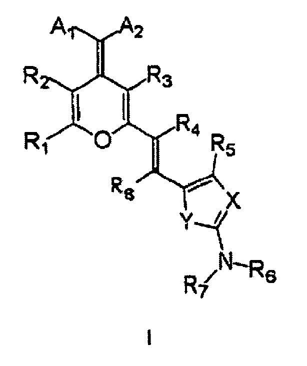 où
R₁ à R₁₂ sont identiques ou différents et représentent l'atome d'hydrogène, un groupe alkyle en C₁-C₆ linéaire ou ramifié, aralkyle, aryle ou aryle substitué;
R₁ et R₂ et/ou R₃ et R₄ et/ou R₄ et R₅ et/ou R₅ et R₁₁ et/ou R₈ et R₅ et/ou R₄ et R₁₂ peuvent former un cycle alicyclique, hétérocyclique ou aromatique, e préférence de 5 ou 6 membres;
R₅ peut être hydrogène, OH, OR₉, N,N-di(alcoyl en C₁-C₆)amino, acétylamino ou halogène;
R₆ et R₇ peuvent former ensemble, un cycle alicyclique ou hétérocyclique;
A₁ et A₂ sont identiques ou différents et sont -CN, -NO₂ ou -COOR₈;
X est -CH, -CR₁₁ ou N, et
Y est O, -NH, -NR₁₂, S ou Se.

2. Dispositif selon la revendication 1, **caractérisé en ce que** la couche luminescente contient comme substance de dopage ou en mélange avec d'autres substances de dopage pour composés luminescents, au moins un composé dans lequel les substituants R₁ et R₂ ou R₃ et R₄ ou R₁ et R₂ et R₃ et R₄ forment un carbocycle à 5 ou 6 membres.

3. Dispositif selon la revendication 1, **caractérisé en ce que** la couche luminescente contient comme substance de dopage ou en mélange avec d'autres substances de dopage pour composés luminescents, au moins un composé de la formule générale II : 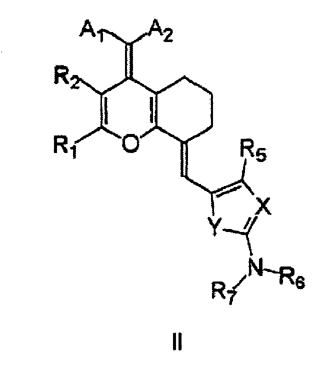 où
R₁, R₂, R₅ à R₇ peuvent être identiques ou différents et peuvent être H, alkyle en C₁-C₆ linéaire ou ramifié, en particulier isopropyle ou t-butyle;
R₁, R₂ peuvent former un cycle alicyclique, hétérocyclique ou aromatique, de préférence de 5 ou 6 membres;
R₁, R₂, R₆, R₇ peuvent être aryle ou aryle substitué identique ou différent;
R₅ peut être OH, OR₈, N, N-di (alcoyl en C₁-C₆) amino, acétylamino ou halogène;
R₆ et R₇ peuvent former ensemble, un cycle alicyclique ou hétérocyclique;
A₁ et A₂ peuvent être identiques ou différents et peuvent être -CN, -NO₂ ou -COOR₈;
R₈ est H, alkyle en C₁-C₆ linéaire ou ramifié ou aryle;
X est -CH, -CR₅ ou N, et
Y est O, -NH, -NR₈, S ou Se.

4. Dispositif selon la revendication 1, **caractérisé en ce que** la couche luminescente contient comme substance de dopage ou en mélange avec d'autres substances de dopage pour composés luminescents, au moins un composé de la formule générale III : 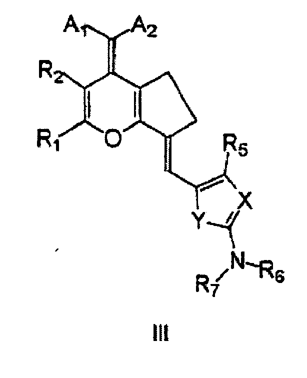 où
R₁, R₂, R₅ à R₇ peuvent être identiques ou différents et peuvent être H, alkyle en C₁-C₆ linéaire ou ramifié, en particulier isopropyle ou t-butyle;
R₁ et R₂ peuvent former un cycle alicyclique, hétérocyclique ou aromatique, de préférence de 5 ou 6 membres;
R₁, R₂, R₅, R₆, R₇ peuvent être aryle ou aryle substitué identique ou différent;
R₅ est OH, OR₈, N, N-di (alcoyl en C₁-C₆) amino, acétylamino ou halogène;
R₆ et R₇ peuvent former ensemble, un cycle alicyclique ou hétérocyclique;
A₁ et A₂ sont identiques ou différents et sont -CN, -NO₂ ou -COOR₈;
R₈ est H, alkyle en C₁-C₆ linéaire ou ramifié ou aryle;
X est -CH, -CR₅ ou N, et
Y est O, -NH, -NR₈, S ou Se.

5. Dispositif selon la revendication 1, **caractérisé en ce que** la couche luminescente contient comme substance de dopage ou en mélange avec d'autres substances de dopage pour composés luminescents, au moins un composé de la formule générale IV : 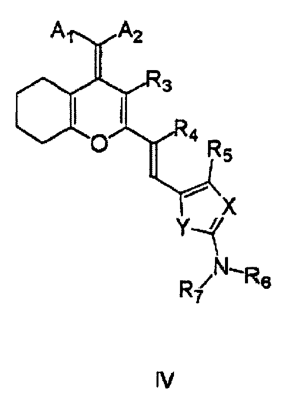 où
R₃ à R₇ peuvent être identiques ou différents et peuvent être H, alkyle en C₁-C₆ linéaire ou ramifié, en particulier isopropyle ou t-butyle;
R₃, R₄ peuvent former un cycle alicyclique, hétérocyclique ou aromatique, de préférence de 5 ou 6 membres;
R₅, R₆, R₇ sont aryle ou aryle substitué identique ou différent;
R₅ peut être OH, OR₈, N,N-di(alcoyl en C₁-C₆) amino, acétylamino ou halogène;
R₆ et R₇ peuvent former ensemble, un cycle alicyclique ou hétérocyclique;
A₁ et A₂ sont identiques ou différents et sont -CN, -NO₂ ou -COOR₈;
R₈ est H, alkyle en C₁-C₆ linéaire ou ramifié ou aryle;
X est -CH, -CR₅ ou N, et
Y est 0, -NH, -NR₈, S ou Se.

6. Dispositif selon la revendication 1, **caractérisé en ce que** la couche luminescente contient comme substance de dopage ou en mélange avec d'autres substances de dopage pour composés luminescents, au moins un composé de la formule générale V : 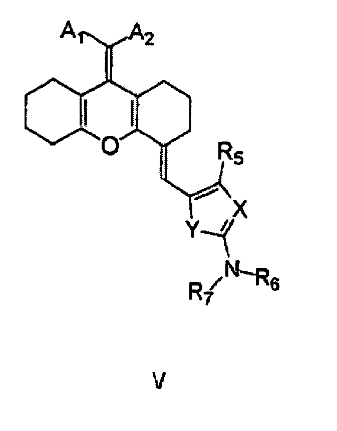 où
R₅ à R₇ peuvent être identiques ou différents et peuvent être H, alkyle en C₁-C₆ linéaire ou ramifié, en particulier isopropyle ou t-butyle;
R₅ à R₇ sont aryle ou aryle substitué identique ou différent;
R₅ peut être OH, OR₈, N,N-di(alcoyl en C₁-C₆) amino, acétylamino ou halogène;
R₆ et R₇ peuvent former ensemble, un cycle alicyclique ou hétérocyclique;
A₁ et A₂ sont identiques ou différents et sont -CN, -NO₂ ou -COOR₈;
R₈ est H, alkyle en C₁-C₆ linéaire ou ramifié;
X est -CH, -CR₅ ou N, et
Y est 0, -NH, -NR₈, S ou Se.

7. Dispositif selon l'une quelconque des revendications 1 à 6, **caractérisé en ce que** les restes R₁ à R₁₂ représentent dans la signification d'alkyle en C₁-C₆, chaque fois méthyle, isopropyle ou t-butyle.

8. Dispositif selon l'une quelconque des revendications 1 à 7, **caractérisé en ce que** la concentration en substance de dopage ou en mélange de dopage dans la couche luminescente se situe dans l'intervalle allant de 1% en poids à 5% en poids, en particulier de 1,5% en poids à 3% en poids, sur base de la quantité de substance luminescente, en particulier sur base du AlQ₃.

9. Dispositif selon l'une quelconque des revendications 1 à 8, **caractérisé en ce que** la couche luminescente contient de préférence, AlQ₃ comme composé luminescent.

10. Dispositif selon la revendication 8 ou 9, **caractérisé en ce qu'**il produit une émission de lumière rouge pure.

11. Dispositif selon l'une quelconque des revendications 1 à 10, **caractérisé en ce que** la couche luminescente contient comme substance de dopage ou en mélange avec d'autres types de substances de dopage pour les composés luminescents, au moins un composé, dans lequel A₁ et A₂ signifient CN.

12. Dispositif selon l'une quelconque des revendications 1 à 11, **caractérisé en ce que** la concentration en substance de dopage en mélange avec les autres types de substances de dopage des substances luminescentes, dans la couche luminescente, est variée dans l'intervalle allant de 0,1% en poids à 50% en poids, sur base du poids total de toutes les substances de dopage.

13. Dispositif selon l'une quelconque des revendications 1 à 7, **caractérisé en ce que** la concentration en substance de dopage se situe dans l'intervalle allant de 0, 1 à 1% en poids, sur base du poids de composé luminescent AlQ₃, de préférence de 0,1-0,8% en poids et **en ce qu'**il produit une lumière blanche lors de l'utilisation de AlQ₃ comme composé luminescent.

14. Composés de la formule générale I : 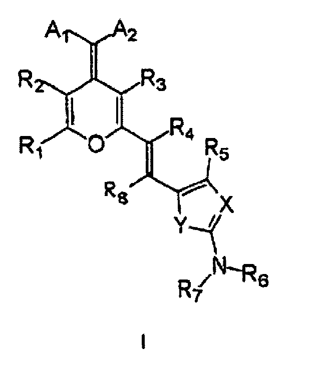 où
R₁ à R₁₂ sont identiques ou différents et représentent l'atome d'hydrogène, un groupe alkyle en C₁-C₆ linéaire ou ramifié, aralkyle, aryle ou aryle substitué;
R₁ et R₂ et/ou R₃ et R₄ et/ou R₄ et R₅ et/ou R₅ et R₁₁ et/ou R₈ et R₅ et/ou R₄ et R₁₂ peuvent former un cycle alicyclique, hétérocyclique ou aromatique, e préférence de 5 ou 6 membres;
R₅ peut être hydrogène, OH, OR₉, N,N-di(alcoyl en C₁-C₆)amino, acétylamino ou halogène;
R₆ et R₇ peuvent former ensemble, un cycle alicyclique ou hétérocyclique;
A₁ et A₂ sont identiques ou différents et sont -CN, -NO₂ ou -COOR₈;
X est -CH, -CR₁₁ ou N, et
Y est 0, -NH, -NR₁₂, S ou Se, avec la condition que Y n'est pas S lorsque X a la signification N et R₅ a la signification aryle.
